Europäisches Patentamt

European Patent Office

Office européen des brevets

(11) Numéro de publication: **0 390 018**
**A2**

## (12) DEMANDE DE BREVET EUROPEEN

(21) Numéro de dépôt: 90105684.6

(22) Date de dépôt: 26.03.90

(51) Int. Cl.5: **H01L 39/14**

(30) Priorité: 30.03.89 FR 8904169

(43) Date de publication de la demande:
**03.10.90 Bulletin 90/40**

(84) Etats contractants désignés:
**AT BE CH DE DK ES FR GB GR IT LI LU NL SE**

(71) Demandeur: **GEC ALSTHOM SA**
**38, avenue Kléber**
**F-75116 Paris(FR)**

(72) Inventeur: **Fevrier, Alain**
**25, Avenue du Parisis**
**F-78310 Maurepas(FR)**
Inventeur: **Verhaege, Thierry**
**22, Allée G. Brassens**
**F-91160 Saulx Les Chartreux(FR)**
Inventeur: **Bonnet, Patrick**
**17, Bois Joli**
**F-90300 Cravanche(FR)**

(74) Mandataire: **Weinmiller, Jürgen et al**
**Lennéstrasse 9 Postfach 24**
**D-8133 Feldafing(DE)**

(54) **Procédé de fabrication d'un conducteur à brins multifilamentaires supraconducteurs, pour applications aux fréquences industrielles, et conducteur en résultant.**

(57) Procédé de fabrication d'un conducteur à brins multifilamentaires supraconducteurs, pour applications aux fréquences industrielles, consistant à préparer d'abord des brins élémentaires, chacun d'eux étant formé à partir d'une pluralité de filaments supraconducteurs noyés dans une matrice métallique puis torsadé, caractérisé par le fait que l'on assemble des brins élémentaires (20) présentant un diamètre compris entre 0,05 mm et 0,25 mm, sans isolation électrique préalable, qu'on les torsade ensemble à chaud (24) avec un pas sensiblement égal à quatre fois leur diamètre et que l'on effecvtue ensuite une opération d'isolation électrique du conducteur.

FIG. 7

## Procédé de fabrication d'un conducteur à brins multifilamentaires supraconducteurs, pour applications aux fréquences industrielles, et conducteur en résultant

La présente invention concerne un procédé de fabrication d'un conducteur à brins multifilamentaires supraconducteurs, et un conducteur en résultant. Un tel conducteur est destiné à transporter aux fréquences industrielles et avec de très faibles pertes des densités de courant élevées.

Un conducteur connu comporte un assemblage d'un nombre élevé de brins élémentaires multifilamentaires. Chaque brin élémentaire est réalisé à partir de filaments supraconducteurs de diamètre inférieur au micron, généralement en niobium-titane , noyés dans une matrice d'alliage cupronickel, ménageant un espacement entre ces filaments. Chaque brin est torsadé conformément au procédé décrit dans le brevet français FR-A-2 556 956 avec un pas de torsade égal à environ quatre fois son diamètre ; il est ensuite recouvert d'une gaine assurant l'isolation électrique. On assemble généralement les brins élémentaires par six autour d'un fil en alliage de cupronickel destiné à assurer à l'ensemble une meilleure tenue mécanique.

Le conducteur obtenu présente un pas de transposition égal à environ dix fois son diamètre. Il peut constituer la base d'un nouvel étage d'assemblage.

On constate que, dans les brins d'un tel conducteur, il existe des courants de circulation entre les couches concentriques de filaments, courants qui vont jusqu'à saturer la capacité de transport des couches les plus chargées. Une telle situation augmente les pertes, et occasionne dans certains cas la disparition de l'état supraconducteur.

Pour réduire l'importance de ce phénomène et obtenir une stabilité suffisante de l'état supraconducteur, on met en oeuvre des brins présentant un très faible diamètre, de l'ordre de 0,1 mm à 0,2 mm. Comme ces faibles dimensions limitent la capacité de transport du brin, il est généralement nécessaire d'en associer un nombre important au sein d'un même conducteur.

L'ensemble des brins élémentaires gainés et assemblés présente alors une compacité assez faible. (La compacité est définie comme le rapport de la section des brins multifilamentaires nus à la section du cercle circonscrit au conducteur). Ceci réduit la densité de courant apparente du conducteur.

La présente invention a pour but de réaliser un conducteur à brins multifilamentaires supraconducteurs susceptible de transporter davantage de courant que les conducteurs antérieurs, avec des pertes comparables, et une compacité nettement supérieure.

La présente invention a également pour but de mettre en oeuvre un procédé de fabrication plus économique que le procédé antérieur.

La présente invention a pour objet un procédé de fabrication d'un conducteur à brins multifilamentaires supraconducteurs pour application aux fréquences industrielles, consistant à préparer d'abord des brins élémentaires, chacun d'eux étant formé à partir d'une pluralité de filaments supraconducteurs noyés dans une matrice métallique puis torsadé, caractérisé par le fait que l'on assemble des brins élémentaires présentant un diamètre compris entre 0,05 mm et 0,25 mm, sans isolation électrique préalable, qu'on les torsade ensemble à chaud avec un pas sensiblement égal à quatre fois leur diamètre et que l'on effectue ensuite une opération d'isolation électrique du conducteur.

De préférence, on opère un tréfilage avant ladite opération d'isolation électrique pour réduire la section du conducteur assemblé et en accroître la compacité.

Selon un mode de réalisation , le diamètre desdits filaments est compris entre 0,05 $\mu$m et 0,25 $\mu$m ; ils sont formés d'un alliage de niobium-titane et ladite matrice est en alliage de cuivre et de nickel.

La présente invention a également pour objet un conducteur à brins multifilamentaires supraconducteur pour applications aux fréquences industrielles obtenu par le procédé précédent.

Lorsque l'on effectue le bobinage de ce conducteur il est très avantageux d'effectuer ladite opération d'isolation électrique, par exemple par imprégnation, après la réalisation du bobinage proprement dit.

D'autres caractéristiques et avantages de la présente invention apparaîtront au cours de la description suivante de modes de réalisation donnés à titre illustratif mais nullement limitatif. Dans le dessin annexe :

- Les figures 1A, 1B, 1C illustrent schématiquement en coupe transversale trois phases de la première étape de la fabrication d'un brin élémentaire multifilamentaire selon l'art antérieur,

- Les figures 2A, 2B, 2C illustrent schématiquement en coupe transversale trois phases de la seconde étape de la fabrication dudit brin,

- Les figures 3A, 3B, 3C illustrent schématiquement en coupe transversale trois phases de la troisième étape de la fabrication dudit brin,

- Les figures 4 et 5 illustrent en perspective les phases de torsadage et d'isolation du même brin de l'art antérieur,

- La figure 6 montre schématiquement en coupe un conducteur de l'art antérieur avec des brins fabriqués suivant les étapes des figures 1 à 5,

- La figure 7 montre schématiquement en coupe un conducteur selon l'invention après assemblage de ses brins,

- La figure 8 montre schématiquement en coupe transversale le conducteur de la figure 7 après une opération de tréfilage, et un gainage.

On décrit tout d'abord un procédé de l'art antérieur.

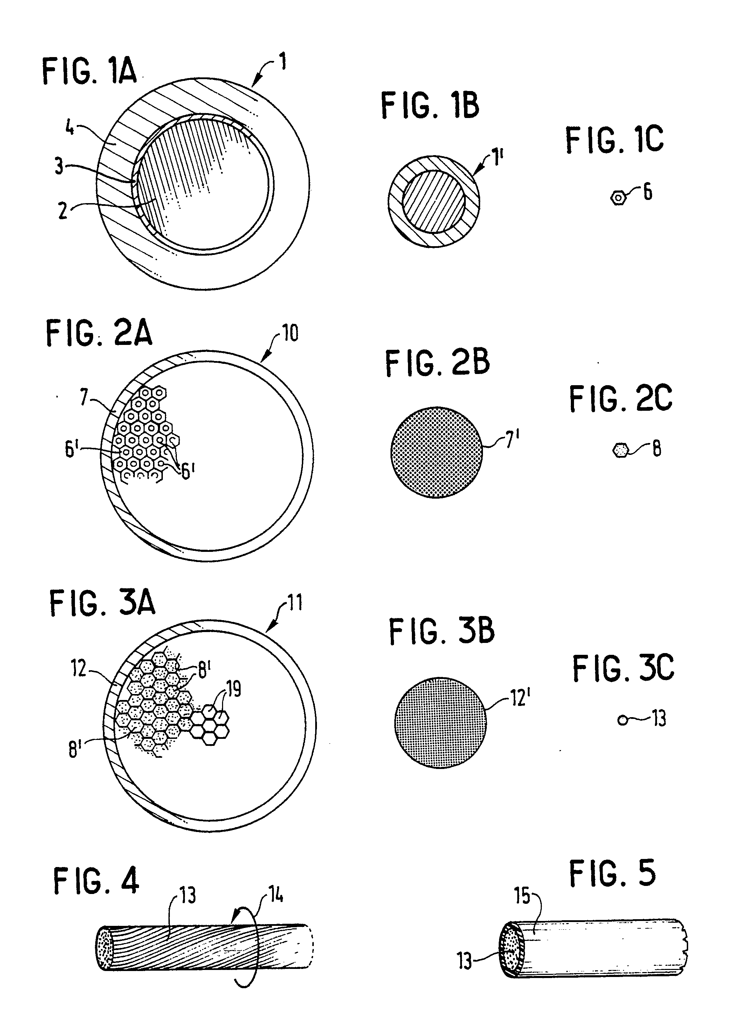

Si on se reporte à la figure 1A on voit que l'on part d'une billette 1, dite d'étage 0, et constituée par un lopin 2 d'alliage de niobium et de titane à 46,5 % de titane, entouré d'une feuille 3 en niobium, dans un corps 4 en alliage de cuivre et de nickel. Cette billette est extrudée, et apparaît en 1' dans la figure 1B ; elle est tréfilée de façon à produire une tige hexagonale 6 (voir figure 1C) de quelques millimètres sur plat. Cette tige 6 est tronçonnée en éléments 6' (voir figure 2A), assemblés dans un corps de billette 7 en alliage de cuivre et de nickel pour former une billette 10 d'étage 1. Celle-ci est transformée de façon analogue à la billette d'étage 0 en 7' et 8 (voir figures 2B et 2C). La tige hexagonale 8 est tronçonnée en éléments 8' pour former une billette 11 d'étage 2 avec un corps de billette 12 en alliage de cuivre et de nickel. On place au centre de la billette 12 quelques tiges hexagonales 19 en cuivre ou en alliage cupronickel pour faciliter la transformation et obtenir les propriétés électriques souhaitées ; ces tiges 19 ont des dimensions analogues à celles des tiges 8'. Comme les précédentes, la billette 11 d'étage 2 est extrudée en 12' (figure 3B) et tréfilée (figure 3C) jusqu'à l'obtention d'un brin multifilamentaire 13.

Ce brin 13 de l'art antérieur peut comporter par exemple 500 000 filaments, ce qui implique l'assemblage à l'étage 1, puis à l'étage 2, d'environ 700 tiges hexagonales 6' ou 8'.

Le diamètre du brin 13 est par exemple de 0,2 mm. Ce brin est torsadé à chaud avec un pas égal à quatre fois son diamètre, soit 0,8 mm. Cette opération est illustrée dans la figure 4 par la flèche 14. Puis le brin 13 est recouvert d'une couche isolante 15 (voir figure 5) ; son diamètre est alors de 0,25 mm, par exemple.

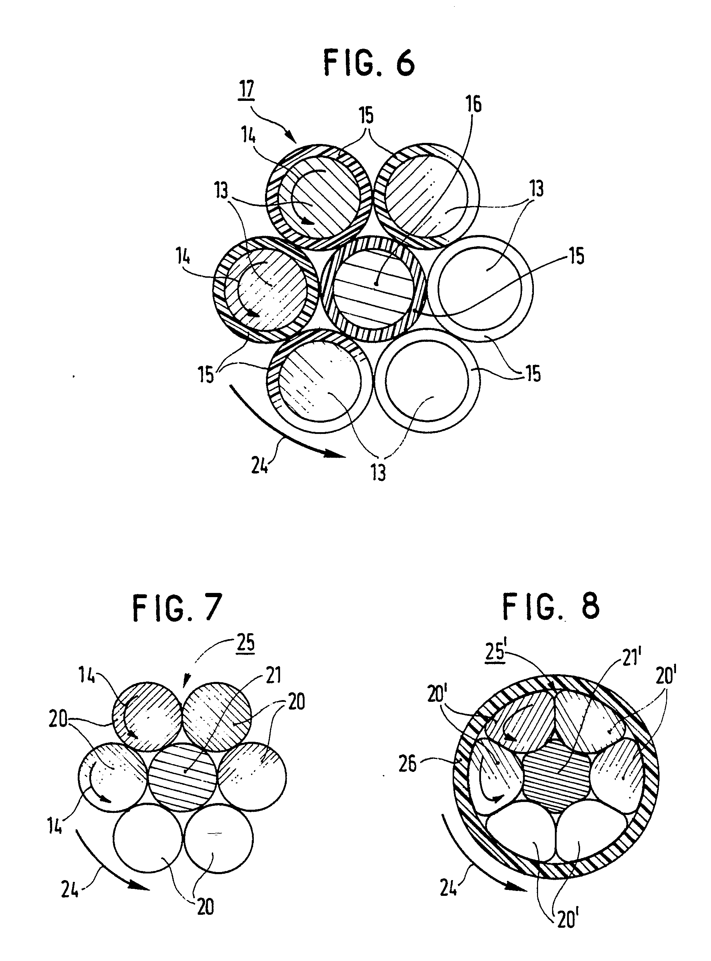

Plusieurs brins 13 sont assemblés pour former un conducteur de l'art antérieur 17 visible dans la figure 6. Dans cette configuration six brins 13 sont disposés autour d'un brin central 16 en alliage cupronickel, muni également d'une gaine isolante 15. Le conducteur 17 assemblé est torsadé avec un pas de transposition égal à environ dix fois son diamètre ; si ce conducteur a un diamètre de 0,75 mm, le pas de transposition sera de 7,5 mm. La flèche 24 schématise le torsadage. La compacité de ce conducteur est de 42,7 %, ce qui est faible.

On décrit ci-dessous le procédé de fabrication selon l'invention. On opère comme dans le procédé de l'art antérieur jusqu'à la phase illustrée dans la figure 4, mais avec moins de filaments. Un brin 20 selon l'invention comportera par exemple 180 000 filaments, ce qui implique la mise en place d'environ 420 tiges hexagonales aux étages 1 et 2 (figures 2A et 3A) au lieu de 700 par le brin 13. Le diamètre final du brin 20 est de 0,12 mm. Le brin 20 est torsadé avec un pas égal à quatre fois son diamètre, soit 0,48 mm. Un tel diamètre et un tel pas de torsade sont susceptibles d'améliorer le comportement du brin en régime alternatif du point de vue stabilité et perte. Un brin 20 présente une capacité de transport égal à 36 % de celle d'un brin 13 de l'art antérieur.

Selon une caractéristique essentielle de l'invention, le brin 20 n'est pas isolé, contrairement au brin 13.

On évite déjà ici une opération coûteuse pour chaque brin.

On assemble alors à chaud six brins 20 selon l'invention autour d'un brin central 21 non isolé en alliage cupronickel (voir figure 7). Cet assemblage à chaud est rendu possible par l'absence de gaine isolante. Les opérations de torsadage des brins et d'assemblage du conducteur peuvent être réalisées simultanément par une machine appropriée, ce qui est une simplification vis-à-vis du procédé antérieur.

On obtient alors un conducteur 25 de diamètre 0,36 mm avec un pas de transpositon de 1,44 mm, ce qui est suffisamment faible pour justifier l'absence d'isolation des brins 20, les courants de circulation entre brins restant modérés. Dans un tel conducteur chaque filament élémentaire évolue entre la surface et le centre du conducteur, selon le pas de torsade du brin 20.

De préférence, le conducteur 25 est compacté par une opération de tréfilage et devient 25' (voir figure 8) ; les brins du conducteur 25' sont référencés respectivement 20' et 21'. Son diamètre passe par exemple de 0,36 mm à 0,33 mm, sans réduction notable de section utile. Le conducteur 25' est alors muni d'une gaine isolante 26 et son diamètre passe alors à 0,38 mm. L'opération d'isolation doit être adaptée pour accepter la surface non lissée du conducteur 25', mais cette opération est moins coûteuse sur ce conducteur que sur les brins 13 car elle s'applique à un conducteur plus gros, et de longueur réduite.

La capacité de transport du conducteur 25' est égale à environ 2,16 fois celle du brin isolé 13 de l'art antérieur, ou à 36 ; de celle du conducteur 17. Sa compacité est de 59,8 %.

Ce conducteur est donc un produit intermédiaire entre le brin 13 et le conducteur 17, dont la stabilité, les pertes et la compacité sont améliorées et dont le coût est diminué.

La stabilité et le niveau de pertes en alternatif, sont aussi bons dans un conducteur 25' que dans un brin de diamètre 0,12 mm de l'art antérieur, mais il transporte six fois plus de courant.

Selon une autre variante de réalisation dans laquelle on veut accroître la capacité de transport, on utilise des brins élémentaires plus gros, de diamètre 0,2 mm par exemple. On obtiendra alors un conducteur selon l'invention ayant la même capacité de transport que le conducteur 17 de l'art antérieur, mais avec un diamètre de 0,6 mm ou de 0,65 mm et un taux de compacité égal à 66,7 % ou 56,8 % selon qu'il est ou non compacté par tréfilage. Mais le pas de transposition étant alors de 2,4 mm, on observera une augmentation des pertes par courant induit acceptable, quoique non négligeable.

Dans toutes les variantes de mise en oeuvre du procédé selon l'invention qui viennent d'être décrites, les longueurs de conducteur à isoler sont fortement réduites par rapport à celles du conducteur de l'art antérieur, ce qui est un avantage économique déterminant. Compte tenu des diamètres des conducteurs à isoler, nettement plus élevés que ceux des brins de l'art antérieur, il est possible d'utiliser un procédé par enrubannage.

Bien entendu, l'invention n'est pas limitée aux modes de réalisation qui viennent d'être décrits. L'assemblage de six brins avec un brin central non supraconducteur n'est qu'un exemple non limitatif. On peut mettre en oeuvre davantage de brins autour d'un brin central par exemple des triplets de triplets, ou même assembler des brins supraconducteurs sans brin central ; l'assemblage doit être le plus compact possible et de forme telle qu'il n'ait pas à subir une déformation trop forte au moment de l'opération finale de tréfilage.

Si dans certaines applications l'opération de compactage par tréfilage n'est pas nécessaire, le conducteur 25 selon l'invention présente encore après son gainage un taux de compacité et un coût améliorés par rapport à ceux du conducteur 17.

## Revendications

1/ Procédé de fabrication d'un conducteur à brins multifilamentaires supraconducteurs, pour applications aux fréquences industrielles, consistant à préparer d'abord des brins élémentaires, chacun d'eux étant formé à partir d'une pluralité de filaments supraconducteurs noyés dans une matrice métallique puis torsadé, caractérisé par le fait que l'on assemble des brins élémentaires (20) présentant un diamètre compris entre 0,05 mm et 0,25 mm, sans isolation électrique préalable, qu'on les torsade ensemble à chaud avec un pas sensiblement égal à quatre fois leur diamètre et que l'on effectue ensuite une opération d'isolation électrique du conducteur.

2/ Procédé de fabrication selon la revendication 1, caractérisé par le fait que, préalablement à ladite opération d'isolation électrique, on réalise un tréfilage pour compacter les brins assemblés (20') et torsadés.

3/ Procédé de fabrication selon l'une des revendications précédentes, caractérisé par le fait que le diamètre desdits filaments est compris entre 0,05 μm et 0,25 μm, qu'ils sont formés d'un alliage de niobium-titane et que ladite matrice est en alliage de cuivre et de nickel.

4/ Conducteur à brins multifilamentaires supraconducteurs noyés dans une matrice métallique, lesdits brins (20) étant torsadés, caractérisé par le fait qu'il est obtenu par le procédé selon l'une des revendications précédentes.

5/ Procédé de fabrication d'un bobinage d'un conducteur à brins multifilamentaires supraconducteurs, pour applications aux fréquences industrielles, caractérisé par le fait que ladite opération d'isolation électrique dudit conducteur est effectuée après l'enroulement dudit bobinage.

FIG. 1A

4

3

2

1

FIG. 1B

1'

FIG. 1C

6

FIG. 2A

7

6'

6'

6'

10

FIG. 2B

7'

FIG. 2C

8

FIG. 3A

12

8'

19

8'

11

FIG. 3B

12'

FIG. 3C

13

FIG. 4

13

14

FIG. 5

15

13

# FIG. 6

# FIG. 7

# FIG. 8